(19) Europäisches Patentamt
European Patent Office
Office européen des brevets

(11) **EP 4 459 496 A1**

(12) **EUROPEAN PATENT APPLICATION**

(43) Date of publication:
**06.11.2024  Bulletin 2024/45**

(21) Application number: **23315150.5**

(22) Date of filing: **02.05.2023**

(51) International Patent Classification (IPC):
*G06F 30/17* (2020.01)      *G06N 20/00* (2019.01)
*G06F 16/00* (2019.01)      *G06F 30/27* (2020.01)
*G06N 3/045* (2023.01)

(52) Cooperative Patent Classification (CPC):
**G06F 30/17; G06F 30/27; G06N 3/042;
G06N 3/045; G06N 3/084; G06N 3/09**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Dassault Systèmes**
**78140 Vélizy-Villacoublay (FR)**

(72) Inventors:
• **MAILLARD, Léopold**
  **78140 Velizy Villacoublay (FR)**
• **BOUCHER, Julien**
  **78140 Velizy Villacoublay (FR)**

(74) Representative: **Bandpay & Greuter**
**11 rue Christophe Colomb**
**75008 Paris (FR)**

(54)    **MACHINE-LEARNING FOR CAD MODEL RETRIEVAL**

(57)    The disclosure notably relates to computer-implemented method of machinelearning for CAD model retrieval based on a mating score. The method comprises providing a dataset of pairs of Boundary Representations (B-Reps) representing mechanical parts, each pair being labeled with mating compatibility data, the mating compatibility data representing an extent of mating compatibility between the mechanical parts represented by the pair. The method also comprises training a neural network based on the dataset, the neural network being configured for taking as input a pair of B-reps representing mechanical parts, and outputting a mating score of a pair of single embeddings, each single embedding corresponding to a B-Rep of the pair, the mating score representing a score of mating compatibility between the mechanical parts represented by the pair.

**Description**

**TECHNICAL FIELD**

The disclosure relates to the field of computer programs and systems, and more specifically to a method, system and program for machine-learning for CAD Model-retrieval.

**BACKGROUND**

A number of systems and programs are offered on the market for the design, the engineering and the manufacturing of objects: CAD is an acronym for Computer-Aided Design, e.g. it relates to software solutions for designing an object. CAE is an acronym for Computer-Aided Engineering, e.g. it relates to software solutions for simulating the physical behavior of a future product. CAM is an acronym for Computer-Aided Manufacturing, e.g. it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise. The PLM solutions provided by.Dassault Systèmes (under the trademarks CATIA, ENOVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production and service.

Within this context, there is still a need for improved solutions for retrieving a CAD model from a database.

**SUMMARY**

It is therefore provided a computer-implemented method of machine-learning for CAD model-retrieval based on a mating score. The method comprises providing a dataset of pairs of Boundary Representations (B-Reps) representing mechanical parts. Each pair is labeled with mating compatibility data. The mating compatibility data represents an extent of mating compatibility between the mechanical parts represented by the pair. The method also comprises training a neural network based on the dataset. The neural network is configured for taking as input a pair of B-reps representing mechanical parts, and outputting a mating score of a pair of single embeddings. Each single embedding corresponds to a B-Rep of the pair. The mating score represents a score of mating compatibility between the mechanical parts represented by the pair.

The method may comprise one or more of the following:

- the neural network comprises:

  ◦ a neural network encoder configured to take as input the pair of B-Reps and output a single embedding for a B-Rep of the pair, and
  ◦ a score neural network configured to take as input a concatenation of the pair of single embeddings and output the mating score;

- the neural network encoder comprises a Siamese graph neural network encoder and/or the score neural network is a multi-layer perceptron neural network;
- the neural network comprises a pooling module applied on the output the Siamese graph neural network encoder and passed as input the multi-layer perceptron neural network;
- the neural network encoder and the score neural network are trained simultaneously by using a loss, the loss penalizing a disparity between the mating compatibility data and the mating score.

It is also provided a neural network trainable according to the method.

It is also provided a method of use of the neural network. The method of use comprises providing a database of B-Reps representing mechanical parts, each B-Rep being associated to a single embedding obtained by applying the neural network to the B-Rep.

The method of use may comprise one or more of the following:

- comprising:

  ◦ obtaining a single embedding of a B-Rep by applying the neural network to the B-Rep;
  ◦ querying the database with the single embedding, including applying the neural network to pairs each consisting of the single embedding and one of respective single embeddings of one or more B-Reps included in the database;
  ◦ retrieving one or more B-Reps from the database based on the mating score resulting from the application of the neural network;

- further comprise ranking the one or more B-Reps based on the mating scores.

The training method or the method of use may further comprise performing a database indexation by applying the neural network to the B-Reps to output respective single embeddings, the database indexation associating to each B-Rep a respective single embedding.

It is further provided a database obtainable by the training method or the method of use.

It is further provided a computer program comprising instructions which, when executed by a computer system, cause the computer system to perform the training method and/or the method of use.

It is further provided a computer readable storage medium having recorded thereon the program, the neural network and/or the database.

It is further provided a computer system comprising a processor coupled to a memory, the memory having recorded thereon the program, the neural network and/or the database.

**BRIEF DESCRIPTION OF THE DRAWINGS**

Non-limiting examples will now be described in reference to the accompanying drawings, where:

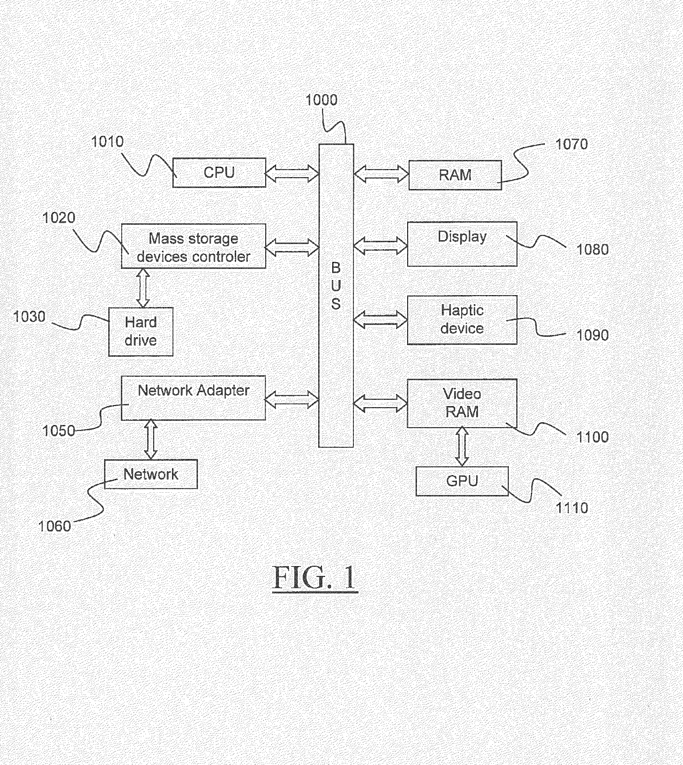

- FIG. 1 shows an example of the system; and
- FIG.s 2 to 7 illustrate the methods.

**DETAILED DESCRIPTION**

It is proposed a computer-implemented method of machine-learning for CAD model-retrieval based on a mating score. The method (also referred to as "training method" or equivalently "learning method") comprises providing a dataset of pairs of Boundary Representations (B-Reps). The pairs of B-Reps represent mechanical parts. Each pair is labeled with mating compatibility data. The mating compatibility data represents an extent of mating compatibility between the mechanical parts represented by the pair. The method also comprises training a neural network based on the dataset. The neural network is configured for taking as input a pair of B-reps representing mechanical parts. The neural network is also configured for outputting a mating score of a pair of single embeddings. Each single embedding corresponds to a B-Rep of the pair. The mating score represents a score of mating compatibility between the mechanical parts represented by the pair.

Such a method forms an improved solution for CAD model-retrieval. Indeed, the neural network is configured to (i.e., trained to) output a mating score of single embeddings corresponding to the input pair of B-reps. As the mating score represents a score of mating compatibility between the mechanical parts represented by the pair, the neural network is trained to determine the extent by which the mechanical parts represented by the pair of B-reps may be assembled together.

The neural network trained by the method may thereby be used for retrieving one or more B-Reps from a database, based on the mating score resulting from the application of the neural network. In other words, the CAD Model-retrieval of the one or more B-Reps may be performed by using the mating score as a search criteria in the database.

The B-Reps obtained from the database may thus be retrieved based on the respect of mating compatibility between the mechanical parts. This ensures that the retrieved one or more B-Reps are representative of mechanical parts that can be effectively mated in the real world with an input query part. The methods and the neural network thus form solutions to assist a designer in selecting B-reps of mechanical parts to be mated during a design phase of the corresponding assembly of the mechanical parts.

Furthermore, not only do the methods assist a designer for retrieving CAD models of mechanical parts that have mating compatibility, but the methods do so efficiently in terms of computing resources (e.g., with respect to CPU and memory usage), and are thus resource-efficient (the method may for example run on a GPU). Indeed, the retrieval is based on the single embeddings and mating scores computed by the neural network (e.g., the single embeddings being output by the Siamese graph neural network encoder, and the mating scores being output by the score neural network as described below), and thus processes vectors belonging in a relatively low dimensional space. This makes the retrieval efficient in terms of CPU and memory usage, for example compared on a mating compatibility retrieval that would be based on more geometrical methods (e.g. mating compatibility identification based on ray-casting or the like). In examples, as said above, the retrieval is so flexible that it can be performed both on a CPU or GPU.

The method of use, or the process comprising the method of use in an online stage (as discussed hereinafter) results in an improved time efficiency. Indeed, thanks to the single embeddings, the method of use allows for fast queries.

Moreover, the method of use is more space efficient: the method relies on computing "signatures" for B-Rep models, which are comparatively more lightweight than the original models.

In addition, new CAD models can be added to indexed database, e.g., by applying the neural network to the new CAD models and adding them in the database in association with the respective single embedding. For example, unseen models may be used to query the database.

Additionally, the method of use is a data-driven method. Indeed, the method of use allows to help assembling pairs, that then may be added to the dataset on which the method is trained.

The method and/or the method of use may be included in a design process, where the method and/or the method of use form a solution to assist a designer in designing an assembly of mechanical parts that correspond to the mating of two or more mechanical parts. The design process may include:

- optionally, obtaining the neural network, for example by executing the method;
- providing a database of B-reps each being associated to a single embedding, for example by performing the database indexation which is discussed hereinafter;
- (*e.g.* by executing the method of use) querying the database with a single embedding of a B-rep that results from applying the neural network to the B-rep (e.g., the output by the Siamese graph neural network encoder as described below), by applying the neural network to pairs each consisting of the single embedding and one of respective single embeddings of one or more B-Reps included in the database, and retrieving one or more B-reps based on the mating score resulting from the application of the neural network (e.g., the application being the output of the score neural network as described below);
- assembling the B-rep corresponding to the single embedding with one or more of (*e.g.* all of) the retrieved B-reps, thereby obtaining a B-rep representing an assembly of mechanical parts.

The design process may further comprise using the obtained B-rep representing an assembly of mechanical parts for manufacturing the assembly of parts.

Using the obtained B-rep for manufacturing the assembly of parts designates any real-world action or series of action that is/are involved in/participate to the manufacturing of the assembly of parts represented by the obtained B-rep. Using the obtained B-rep for manufacturing the assembly of parts may for example comprise the following steps:

- editing the obtained B-rep in view of manufacturing;
- performing simulation(s) based on the obtained B-rep and/or a corresponding feature tree, such as simulations for validation of mechanical, use and/or manufacturing properties and/or constraints (e.g., structural simulations, thermodynamics simulation, aerodynamic simulations);

- editing the obtained B-rep (or feature tree thereof) based on the results of the simulation(s);
- optionally (i.e. depending on the manufacturing process used, the production of the mechanical product may or may not comprise this step), (e.g., automatically) determining a manufacturing file/CAM file based on the (e.g., edited) B-rep (or feature tree thereof), for production/manufacturing of the manufacturing product;
- sending the B-rep (*e.g.* in the form of a CAD file) and/or the manufacturing file/CAM file to a factory; and/or
- (e.g., automatically) producing/manufacturing, based on the determined manufacturing file/CAM file or on the B-rep , the assembly of parts originally represented by the obtained B-rep. This may include feeding (e.g., automatically) the manufacturing file/CAM file and/or the CAD file to the machine(s) performing the manufacturing process.

This last step of production/manufacturing may be referred to as the manufacturing step or production step. This step manufactures/fabricates the assembly of parts based on the CAD model thereof (*e.g.* the B-rep) and/or the CAM file, e.g., upon the CAD model and/or CAD file being fed to one or more manufacturing machine(s) or computer system(s) controlling the machine(s). The manufacturing step may comprise performing any known manufacturing process or series of manufacturing processes, for example one or more additive manufacturing steps, one or more cutting steps (e.g. laser cutting or plasma cutting steps), one or more stamping steps, one or more forging steps, one or more bending steps, one or more deep drawing steps, one or more molding steps, one or more machining steps (e.g. milling steps) and/or one or more punching steps.

It is to be noted that, not only do the methods improve the design process, and thus the whole design and manufacturing process, because they allow for a resource-efficient retrieval of mechanical parts which are compatible to be mated with an input query part so that the methods improve efficiency and ergonomics of the design (they assist the designer during the design), but they also improve the mechanical assembly of parts that is manufactured downstream to the design. Indeed, because the methods allow the retrieval of a mechanical part (or more) in a database which is the most suited for being assembled with a given (query) mechanical part, the assembly of parts that results from assembling these mechanical parts (or rather their B-reps) during design exhibits improved physical performances, and notably improved mating strength. Indeed, the assembly results from assembling the parts identified as being the most suitable for mating, thanks to the methods.

The method is computer-implemented. This means that steps (or substantially all the steps) of the method are executed by at least one computer, or any system alike. Thus, steps of the method are performed by the computer, possibly fully automatically, or, semi-automatically. In examples, the triggering of at least some of the steps of the method may be performed through user-computer interaction. The level of user-computer interaction required may depend on the level of automatism foreseen and put in balance with the need to implement user's wishes. In examples, this level may be user-defined and/or pre-defined.

A typical example of computer-implementation of the methods is to perform such methods with a system adapted for this purpose. The system may comprise a processor coupled to a memory and a graphical user interface (GUI), the memory having recorded thereon a computer program comprising instructions for performing the methods. The memory may also store a database. The memory is any hardware adapted for such storage, possibly comprising several physical distinct parts (e.g. one for the program, and possibly one for the database).

FIG. 1 shows an example of the system, wherein the system is a client computer system, *e.g.* a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the methods. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the methods by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the methods. The computer program may alternatively be stored and executed on a server of a cloud computing environment, the server being in communication across a network with one or more clients. In such a case a processing unit executes the instructions comprised by the program, thereby causing the methods to be performed on the cloud computing environment.

The training method is for machine learning for CAD model-retrieval based on a mating score. In other words, the method leverages from machine learning to provide a solution for retrieving (obtaining, e.g., from a database) a CAD model based on a mating score. In yet other words, the mating score is a criterion for the CAD Model-retrieval, e.g., through a look-up of the database or other data structure in non-volatile memory that takes said mating score into account. Such a criterion may be used, for example, by obtaining other mating scores associated to CAD models in said database or other data structure (e.g., already stored in said database or obtained by performing an appropriate transformation) and determining whether there is an agreement (exact or approximate for example, a difference within a tolerance of 5 per cent or more, e.g., 10 per cent) between the mating score output by the neural network and said other mating scores for returning the CAD models.

As known per se from the field of machine-learning, the processing of an input by a neural network includes applying operations to the input, the operations being defined by data including weight values. Training a neural network thus includes determining values of the weights based on a dataset (configured for such training), such a dataset being possibly referred to as a learning dataset or a training dataset. For that, the dataset includes data pieces each forming a respective training sample. The training samples represent the diversity of the situations where the neural network is to be used after being trained. The dataset may comprise a number of training samples higher than 100, 1000, 10000, or more (e.g., 25000), or 100000 or more. -

The method comprises providing the dataset. Providing the dataset may comprise obtaining such a dataset from a data storage medium and/or downloading it from a remote location. Providing the dataset may alternatively comprise creating the dataset, which may include annotating B-reps, as further discussed hereinafter.

Such a dataset is of pairs of Boundary Representations (B-Reps). Any B-rep described herein is a 3D representation of a mechanical part. Specifically, the B-rep is a persistent data representation of the mechanical part. The B-rep may be the result of computations and/or a series of operations carried out during a designing phase of the represented mechanical part. The shape of the mechanical part displayed on the screen of the computer when the modeled object is represented may be (e.g. a tessellation of) the B-rep.

A B-Rep includes topological entities and geometrical entities. Topological entities are: face, edge, and vertex. Geometrical entities are 3D objects: surface, plane, curve, line, point. By definition, a face is a bounded portion of a surface, named the supporting surface. An edge is a bounded portion of a curve, named the supporting curve. A vertex is a point in 3D space. They are related to each other as follows. The bounded portion of a curve is defined by two points (the vertices) lying on the curve. The bounded portion of a surface is defined by its boundary, this boundary being a set of edges lying on the surface. The boundary of the edges of the face are connected by sharing vertices. Faces are connected by sharing edges. Two faces are adjacent if they share an edge. Similarly, two edges are adjacent if they share a vertex. In the CAD system, the B-Rep gathers in an appropriate data structure the "is bounded by" relationship, the relationship between topological entities and supporting geometries, and mathematical descriptions of supporting geometries. An internal edge of a B-Rep is an edge shared by exactly two faces. By definition, a boundary edge is not shared, it bounds only one face. By definition, a boundary face is bounded by at least one boundary edge. A B-Rep is said to be closed if all its edges are internal edges. A B-Rep is said to be open if it includes at least one boundary edge. A closed B-Rep is used to model a thick 3D volume because it defines the inside portion of space (virtually) enclosing material. An open B-Rep is used to model a 3D skin, which represents a 3D object the thickness of which is sufficiently small to be ignored.

A key advantage of the B-Rep over any other representation types used in CAD modeling is its ability to represent arbitrary shapes exactly. All other representations in use, such as point clouds, distance fields and meshes, perform an approximation of the shape to represent by discretization. The B-Rep, on the other hand, contains surface equations that represent the exact design and therefore constitutes a true "master model" for further manufacturing, whether this be generation of toolpaths for CNC, or discretizing into the correct sample density for a given 3D Printer technology. In other words, by using a B-Rep, the 3D model may be an exact representation of the manufactured object. The B-Rep is also advantageous for simulating the behavior of a 3D model. In terms of stress, thermal, electromagnetic or other analysis, it supports local refinement of the simulation meshes to capture physical phenomena, and for kinematics it supports true contact modeling between curved surfaces. Finally, a B-Rep allows a small memory and/or file footprint. The STEP data format may be used for representing the B-Rep in a computer system; it has an ASCII structure and is therefore easy to read. First, because the representation contains surfaces based only on parameters. In other representations such as meshes, the equivalent surface comprises up to thousands of triangles. Second, because a B-Rep doesn't contain any history-based information.

Besides vertices, faces and edges, each B-Rep may also comprise co-edges. A co-edge is an oriented edge, i.e., an edge of the B-Rep with additional orientation information. The co-edges thereby define an ordering around the B-Rep faces and the faces adjacency, i.e., they define the topology of the B-Rep. The co-edges link the B-Rep entities altogether. Each co-edge has one parent face (i.e., the face for which it defines a bound), one parent edge, (i.e., by definition a co-edge is an oriented edge and thus has a parent edge), one mate co-edge which is the co-edge having the same parent edge, one next co-edge, corresponding to the next co-edge in the loop where the co-edge belongs, and one previous co-edge, corresponding to the previous co-edge in the loop where the co-edge belongs. Each co-edge maintains an adjacency relationship with the next and previous co-edge around its parent face, the mating co-edge on the adjacent face, the parent face and the parent edge.

The B-Rep may also be represented by a B-Rep graph. Such a graph represents both the geometry and the topology of a B-Rep, as it comprises graph nodes representing the elements of the B-Rep (edge, face, and/or co-edge) and graph edges representing the topological relationships between the elements represented by the nodes connected by the edges. In examples, each graph node may represent a respective edge, a respective face or a respective co-edge of the respective B-Rep. This means that for each edge of the B-Rep, there is a respective graph node, for each face of the B-Rep, there is a respective graph node, and/or for each co-edge of the B-rep, there is a respective graph node. In other examples, a B-Rep graph may comprise graph nodes which only represent respective faces and the edges of the B-Rep. Alternatively, a B-Rep graph may comprise graph nodes which only represent respective edges of the B-Rep. Each graph node may further comprise a geometrical and/or topological feature associated with (i.e., attached to) the graph nodes. The feature is data, for example a vector (also referred to as feature vector), associated with the node and describing geometrical data and/or topological data characterizing the B-Rep element represented by the graph nodes.

A B-Rep (e.g. represented in the STEP file format) may be converted into a B-Rep graph (e.g., by using a STEP file parser when the B-Rep is represented in the STEP file format) or by loading the parts of said B-Rep using a CAD backend and extracting the relevant features. For example, the conversion into a B-Rep graph may comprise mapping the B-Rep edges and faces (that is, topological entities and for example excluding co-edges) into graph nodes (i.e., graph vertices), and mapping the adjacency of said topological entities into graph edges. Vertex features encode the geometrical properties of the corresponding entity. In other example, the conversion may also include passing additional adjacency matrices indicating the neighboring entities of each type of topological entity.

The B-Rep may represent the geometry of the mechanical part or assembly of parts (or equivalently an assembly of parts, as the assembly of parts may be seen as a part itself from the point of view of the method, or the method may be applied independently to each part of the assembly), or more generally any rigid body assembly (e.g. a mobile mechanism). The B-Rep may thus represent an industrial product which may be any mechanical part, such as a part of a terrestrial vehicle (including e.g. car and light truck equipment, racing cars, motorcycles, truck and motor equipment, trucks and buses, trains), a part of an aerial vehicle (including e.g. airframe equipment, aerospace equipment, propulsion equipment, defense products, airline equipment, space equipment), a part of a naval vehicle (including e.g. navy equipment, commercial ships, offshore equipment, yachts and workboats, marine equipment), a general mechanical part (including e.g. industrial manufacturing machinery, heavy mobile machinery or equipment, installed equipment, industrial equipment product, fabricated metal product, tire manufacturing product), an electro-mechanical or electronic part (including e.g. consumer electronics, security and/or control and/or instrumentation products, computing and communication equipment, semiconductors, medical devices and equipment), a consumer good (including e.g. furniture, home and garden products, leisure goods, fashion products, hard goods retailers' products, soft goods retailers' products), a packaging (including e.g. food and beverage and tobacco, beauty and personal care, household product packaging).

Each pair of B-Reps (in the provided dataset) is labeled with mating compatibility data. By "mating compatibility data" it is meant any value (e.g., the value being a binary value or a real value, or even an alphanumeric value) associated to the pair of B-Reps. The mating compatibility data represents an extent of mating compatibility between the mechanical parts represented by the pair, for example a binary value or a real (non-negative) value indicative of such extent. By "mating compatibility" it is meant any indicator on the extent by which the mechanical parts represented by both B-Reps may be mated (i.e., assembled) together. The mating compatibility data may thus have a value that indicates if the mechanical parts represented by both B-Reps can be mated together, for example of one if said parts may be mated or zero if these cannot be mated. The mating compatibility data may also comprise intermediate values between zero and one. For example, a mating compatibility data that comprises a value of zero may represent no mating compatibility between both mechanical parts, and a value of 1 may represent that the mechanical parts represented by the pair of B-Reps can be mated together. As B-Reps may be mated together (due to the mating compatibility data having value 1), mates may be defined between the two mechanical parts which constraints them. This may be the case when the mating compatibility data is binary value, wherein a value of zero indicates no mating compatibility and a value of one indicates complete mating compatibility. The mating data may alternatively be a (non-negative) real value alternating between a real valued range (for example [0,1]), wherein the lowest value of the real valued range indicates no mating compatibility and the highest value indicates a higher mating compatibility and values in between indicate a mating of compatibility lower than the higher mating compatibility. It is to be understood that the values above are examples, and other values or ranges may be used (for example 0 and 10 instead of 0 and 1, or the range [0, 10] instead of [0,1]). In examples, the mating compatibility data may have a higher mating compatibility values (closer to 1) to the pair of B-Reps that can be mated with constraints that reduces by a lot the degrees of freedom (e.g. a cylindrical constraint, or a slider constraint), and a lower compatibility value to the pairs of parts that can be mated with constraints that still allow a lot of freedom in motion (e.g. planar constraint).

In examples, providing the dataset may comprise annotating the pairs of B-Reps with mating compatibility data. For example, providing the dataset may comprise obtaining pairs of B-Reps (representing, for example, mechanical parts) from a pre-existing dataset (without previous mating compatibility data).

In some examples, for a given pair of B-Reps in the pre-existing dataset, the annotating may comprise labeling positively (i.e., creating mating compatibility data having a value of one) said pair if said pair has been mated together at least one time together in the pre-existing dataset. The annotating may alternatively comprise labeling negatively said pair (i.e., creating mating compatibility data having a value of zero), by randomly select two parts in the pre-existing dataset which have not been mated together in an assembly. The dataset may thus comprise negatively labeled pairs in addition to positively labelled ones. This improves robustness of the training. Indeed, the negatively labeled pairs correspond to pairs which cannot be mated. Thus the neural network is trained to detect when a pair of B-Reps cannot be mated.

In other examples, for a given pair of B-Reps in the pre-existing dataset, the annotating may count the number of unique assemblies where said pair is mated. The annotating may assign a higher mating compatibility score to the pairs that are represented in several assemblies. In other words, pairs that are commonly mated together (e.g. a bot and its nut) will be labeled with a higher value. For a given pair, the annotation may be:

$$number\_of\_assemblies\_involving\_the\_pair$$

$$10 \times number\_of\_assemblies\_involving\_the\_pair$$

$$2^{number\_of\_assemblies\_involving\_the\_pair}$$

In these examples, the annotating may annotate negatively said pair if said pair has not been mated together in the entire dataset.

The method comprises training the neural network based on the dataset. The neural network is a function comprising a collection of connected nodes, also called "neurons". Each neuron receives an input and outputs a result to other neurons connected to it. The neurons and the connections linking each of them have weights, which are adjusted via a training. In the context of the present disclosure, by "training a neural network based on a dataset", it is meant that the dataset is a learning/training dataset of the neural network, based on which the values of the weights neural network are set. In other words, training determines values of the weights of the neural network based on the pair of B-Reps and its mating compatibility data.

The training may be a supervised training. The method may set least part of the data in the data structure of the dataset to be used as ground truth data, to be used for training in supervised mode. As known from the field of machine learning, the neural network may thus compare the output with the ground truth data, the weights of the neural network may be adjusted by the training so that the output of the neural network is consistent with the ground truth data.

The neural network is configured for taking as input a pair of B-Reps representing mechanical parts. The B-Reps may be taken as input in any manner. In examples, the neural network may take as input a B-Rep graph representation of the each B-Rep of the pair. In other words, the neural network may take as input, for each B-Rep of the pair, a graph representation of the B-Reps which represents the topological relationships between the elements represented by the nodes connected by the edges.

The neural network may comprise a neural network encoder. The neural network encoder is a neural network configured to (i.e. trained to) determine a mapping (encoding) between the original input space of the dataset (i.e., a space of B-Reps) and a low-dimensional space known as the embedding space or latent space. The neural network encoder is configured to take as input the pair of B-Reps (for example, as a B-Rep graph representation) and output a single embedding (e.g., the single embedding being a vector representing the topological and/or geometrical entities) of each B-Rep of the pair. In other words, the neural network encoder outputs one single embedding for each input B-Rep.

The neural network is configured for outputting a mating score of a pair of single embeddings. Each single embedding corresponds to a B-Rep of the pair. By single embedding it is meant any data, such as a (multi-dimensional) vector having values that are representative of a B-Rep of the pair, for example, of its topology and/or geometry. In other words, the single embedding may be any data such that it allows the discrimination of the topological and/or geometrical entities of a B-Rep of the pair.

The neural network may also comprise a score neural network. The score neural network is a neural network (e.g., deep neural network model) configured to output the mating score based on its input. The score neural network is configured to take as input a concatenation of the pair of single embeddings and output the mating score. In other words, the score neural network is configured to take as input concatenated single embeddings and outputs the mating score.

The mating score represents a score of mating compatibility between the mechanical parts represented by the pair. The score may be a (e.g., non-negative) value representative of the mating compatibility between the mechanical parts represented by the pair of single embeddings. In other words, the mating score, output by the method, is a value representative of the extent by which the mechanical parts represented by both single embeddings may be assembled together. As the training determines values of the weights of the neural network based on the dataset, the neural network leverages from the mating compatibility data from which the neural network is trained for outputting the mating score. In other words, the output mating score is dependent on the values of the weights of the neural network which have been set by the training. Indeed, as the neural network is trained with pairs of B-Reps labeled with mating compatibility data, mating score is consistent with the values of extent of mating compatibility as captured in the training dataset (i.e. the mating compatibility data). This allows to implement a supervised training, where the pairs of B-Reps labeled with mating compatibility data form ground truth data that the neural network is trained to respect when predicting mating score. The weights of the neural network are thereby adjusted by the training so that the output of the neural network (i.e., the mating score) is consistent with the ground truth data (i.e., the value comprised by the mating compatibility data).

The method thus improves CAD model-retrieval. Indeed, the mating score output by the neural network provides a criterion for retrieving CAD models (in a data structure such as a database) corresponding to an input query B-Rep. For example, the CAD Model-retrieval may comprise searching CAD models (represented by B-Reps) in the data structure by inputting the input query B-Rep. Hence, the CAD Model-retrieval is highly efficient and returns relevant results. This is all thanks to the way the neural network is trained by the method. On the one hand, the method leverages concomitantly from the topology and/or geometry of the pairs of B-Reps and its respective mating compatibility (as represented in the mating compatibility data) and thus improves the accuracy of the CAD model-retrieval based on the mating compatibility. On the other hand, as the mating score provides an indicator of the mating compatibility with an input query part, this makes CAD model-retrieval highly efficient.

Moreover, when the neural network comprises the neural network encoder and the score neural network, the accuracy and the efficiency of the neural network for CAD model-retrieval is further improved. Indeed, on one hand the neural network encoder focuses on the extraction of the topological and/or geometrical entities of the B-Rep in a low dimensional representation, as the single embedding has lower memory requirements with respect to a complete B-Rep. On the other hand, the score neural network focuses on determining the score from the concatenation of the single embeddings, and hence determines the mating score that represents the mating compatibility of the B-reps The single embedding is indeed a low dimensional (in other words, compact) representation of a B-Rep that costs less, in terms of memory requirements (storage, memory footprint) than the corresponding B-rep model.

The neural network encoder may comprise a Siamese graph neural network (GNN) encoder. The Siamese graph neural network encoder may be a neural network encoder which is applied twice, with the same weights to each B-Rep of the input pair. In other words, in implementations, at each training iteration, a first B-Rep of the pair is fed as input to the Siamese graph neural network encoder, then the other B-Rep of the pair is fed as input, and concatenating the resulting single embeddings to apply the score module, and finally update the weights of both the encoder and the score module by backpropagation of the score loss function. In other words, the GNN encoder is applied twice during a single training iteration, but its weights are updated once, at the end; so the same weights are applied to both parts by applying the same network twice. In yet other words, the term "Siamese" only indicates that there are two distinct inputs but apply one single network. In other words, the weights of the Siamese graph neural network encoder (set in the training) may be applied on the graph's nodes and edges of each input B-Rep (listing its topological entities, their geometrical features and/or adjacencies) to compute a respective single embedding. In examples, the training updates the weights of the Siamese graph neural network encoder by backpropagating the result of a loss after both input B-Reps have been processed. The Siamese graph neural network encoder may perform any kind of data processing to the input pair of B-Reps so as to obtain the B-Rep graphs, e.g., by applying a STEP parser on to said B-Reps when said B-Reps are in the step format.

Additionally or alternatively, the score neural network may be a multi-layer perceptron neural network. The multi-layer perceptron neural network may comprise fully connected neurons. The multi-layer perceptron neural network may comprise an input layer, one or more (e.g., a plurality of) hidden layer(s) and an output layer. The multi-layer perceptron neural network may be trained to perform a mapping between the concatenation of single embeddings to the mating score, that is, a real value. The multi-layer perceptron neural network may be a mapping of the type

$\mathbb{R}^{2 \times d} \rightarrow \mathbb{R}^1$, where d denotes the dimension of a single embedding. The multi-layer perceptron neural network may be kept lightweight (i.e., with a relatively low number of fully connected neurons) so it can be applied to a large amount of pairs within a reasonable amount of time. In other words, in the neural network, the single embeddings are output by the Siamese graph neural network encoder, and the mating scores are output by the score neural network being the multi-layer perceptron neural network.

This further improves the efficiency of the CAD model-retrieval. On one hand, the Siamese graph neural network encoder uses identical weights for outputting the single embeddings of each graph representation (i.e., a B-Rep graph) of the input B-Reps. Hence, the goal of the encoder is to compute signatures/ single embeddings from which our second network (score module) will be good at computing the mating compatibility score and thus minimizing the loss. This results in that the neural network is able to determine the mating compatibility between the input B-Reps more efficiently.

The neural network may comprise a pooling module applied on the output the Siamese graph neural network encoder. The pooling module may comprise pooling layers which down sample the output of the Siamese graph neural network encoder, that is, the single embeddings. The result of the application of the pooling module may be passed as input to the multi-layer perceptron neural network, that is, the result of the application of the pooling module for each respective single embedding may be concatenated and then passed to the multi-layer perceptron neural network. In examples, the neural network encoder may further comprise the pooling module at the output of the Siamese network, in other words, on the output of the Siamese network for each B-Rep of the pair. In yet other words, the single embedding for a respective B-Rep of the pair is the output after the application of the pooling module.

This results in an improved accuracy and efficiency for the determination of mating compatibility, as use of the pooling module ensures that the single embedding is a low dimensional representation. Thereby, the memory requirements are significantly reduced.

In examples, the Siamese graph neural network encoder may output a plurality of vector embeddings for each input B-Rep graph. The pooling module may be applied to each plurality of vector embeddings to obtain a single embedding. The pooling module may apply several pooling operations, e.g., Max Pooling (computing the maximum value for coordinates of the single embeddings), Sum Pooling or Mean Pooling operations. In other words, the pooling module may be the Max Pooling, the Sum Pooling or the Mean Pooling. The encoder may for example first output one embedding per graph node of the B-rep graph representation (so one vector embedding per e.g. face & edge of the B-rep), so pooling is applied to have a single, fixed-size embedding per part.

A graph representation of a B-rep that contains n topological entities (e.g. faces & edges) may be constructed and passed to the GNN encoder. The graph has therefore n nodes. The GNN encoder will output a fixed-size (e.g. 256) vector embedding (1-dimensional tensor) for each of these nodes, resulting here in a [n×256] embedding for the whole part. Assume that the second part of the pair has m topological entities, the embedding output by the encoder would be [m×256].The pooling module is applied at the end of the Siamese graph neural network encoder (prior to performing the concatenation). The application of the Siamese graph neural network encoder allows to obtain a [1 × 256] tensor for each part, regardless of the amount of topological entities $n$ & $m$ (so that the score neural network receives as input a concatenation of the pair of single embeddings with a fixed size). Their concatenation results in a vector of size 512, and thus quite compact in terms of memory footprint.

The neural network encoder and the score neural network may be trained simultaneously by using a loss. By "trained simultaneously" it is meant that the weights of the neural network encoder and of the score neural network are adjusted at the same time (i.e., in a same training process) with the loss. In examples, the neural network encoder may be the Siamese graph neural network encoder and the loss may adjust simultaneously the weights of the Siamese graph neural network encoder along with the weights of the score neural network. For example, the loss may output a single loss value and backpropagate it to adjust the weights of the Siamese graph neural network encoder and the score neural network.

The loss may penalize a disparity between the mating compatibility data and the mating score. The loss may penalize the disparity by measuring a distance function between the mating compatibility data and the mating score. For example, the distance function may be a binary-cross entropy (the loss being a binary cross-entropy loss) when the mating compatibility data comprises binary values; the loss thus enforces the mating score to be a binary value in agreement with the binary values of the mating compatibility data. The binary-cross entropy loss may be of the form:

$$ BCE = -\frac{1}{N} \sum_{i=0}^{N} y_i \cdot log(\hat{y}_i) + (1 - y_i) \cdot log(1 - \hat{y}_i) $$

Alternatively and/or additionally, the distance function may comprise Euclidean distance (the loss being for example a mean squares loss) when the mating compatibility data comprises real values; the mating score thereby being enforced to be real value. The mean squared error loss may be of the form:

$$ MSE = \frac{1}{n} \sum_{i=1}^{n} (y_i - \tilde{y}_i)^2 $$

This improves the efficiency of CAD model-retrieval. The loss indeed improves the efficiency by simultaneously updating weights for obtaining a low-dimensional representation of the topological and/or geometrical features of the pair of B-Reps while simultaneously enforcing a mating score in agreement with the mating compatibility data.

In examples, the method may simultaneously train a Siamese graph neural network encoder, that takes as input a pair of B-Reps with mating compatibility data, the pooling module applied on the output of the Siamese graph neural network encoder, thereby outputting single embeddings for each B-Rep of the pair, and a compatibility score module comprising the score neural network that takes as input the concatenation of the single embeddings and outputs a mating score. In this example, the training is end-to-end: a single loss value is computed and backpropagated to adjust the weights of the Siamese graph neural network encoder and the compatibility score module. The loss measures the distance between the predicted score outputted by the compatibility score modules and the mating compatibility data.

It is further provided a neural network trainable according to the method (for example having been trained according to the training method), that is, a computer-implemented neural network data structure having the weights of a neural network trained by the method. In other words, the weights of the neural network may be definitely set (i.e., without any further post-processing of such weights) after performing the training by the method.

It is further provided a method of use of the neural network that is, the neural network having been trained according to the training method. The method of use comprises providing a database of B-Reps representing mechanical parts. Each B-Rep in the database is associated to a single embedding obtained by applying the neural network to the B-Rep.

It is further provided a process comprising performing the method and/or the method of use. Performing the method may also be called an "offline stage", and performing the method of use may be called "online stage". The offline stage and the online stage may be performed by different systems, different entities or at different places.

By "database", it is meant any collection of data (i.e. information) organized for search and retrieval (e.g. a relational database, e.g. based on a predetermined structured language, e.g. SQL). When stored on a memory, the database allows a rapid search and retrieval by a computer. Databases are indeed structured to facilitate storage, retrieval, modification, and deletion of data in conjunction with various data-processing operations. The database may consist of a file or set of files that can be broken down into records, each of which consists of one or more fields. Fields are the basic units of data storage. Users may retrieve data primarily through queries. Using keywords and sorting commands, users can rapidly search, rearrange, group, and select the field in many records to retrieve or create reports on particular aggregates of data according to the rules of the database management system being used.

It is further provided a database obtainable according to the method of use, that is, a collection of data organized for search and retrieval wherein the data pieces comprise (e.g., consist of) respective B-rep and associated to a respective single embedding.

By "associated to" it is meant that the B-Rep and the single embedding are related and have a relation in the database, that is, there is a mutual link between two objects in the database by application of the neural network to the B-Rep. The association of a B-rep and its single embedding within the database is however a matter of database implementation and does not need being further discussed.

The method of use may comprise obtaining a single embedding of a B-Rep (also called "new B-Rep") by applying the neural network to the B-Rep. In examples, the neural network may comprising the Siamese graph neural network encoder and the score neural network trained according to the training method. The method of use may apply the Siamese graph neural network encoder to the B-Rep and obtain the single embedding from said Siamese graph neural network encoder.

The method of use may also comprise querying the database with the single embedding. The querying includes applying the neural network to pairs each consisting of the single embedding and one of respective single embeddings of one or more B-Reps included in the database. In examples (e.g., when the neural network may comprising the Siamese graph neural network encoder and the score neural network), the method may set the single embedding as part of a query (e.g., via a SQL instruction) and search the database with the single embedding. The method of use may for example apply the neural network to the one or more B-Reps included in the database to obtain a respective single embedding (for example at the output of the Siamese graph neural network encoder or at the output of the pooling module when such B-Reps are not associated with a respective single embedding) for when performing the query i.e., while traversing the database of B-Reps with the query. The score neural network may take as input a concatenation of the pair of single embeddings (i.e., the single embedding obtained from the new B-Rep and each of the one or more B-Reps included in the database) and output the corresponding mating score.

The method of use may also comprise retrieving one or more B-Reps from the database based on the mating score resulting from the application of the neural network. For example, the method of use may output the B-Rep of the database having the highest mating score with respect to the new B-Rep. Alternatively, the method may output, for example, a plurality of B-Reps having a score above a predetermined threshold. In examples, if more than one B-Rep of the database have the same highest mating score (up-to numerical tolerance) the method may output all of said B-Reps.

This results in a highly efficient retrieval of B-Reps, as the retrieved B-Reps from the database are found with respect to their respective mating compatibility with respect to the new B-Rep.

The method of use may comprise ranking the one or more B-Reps based on the mating scores. This results in that the method may provide relevant results. Indeed, the method of use may rank in the one or more B-Reps in decreasing order of the mating scores, so as to prioritize retrieved B-Reps that are more relevant. The B-Reps may be, for example, displayed to an end user according to the ordering set by the ranking.

The method or the method of use may further comprise performing a database indexation. By database indexation it is meant any set of operations allowing to store a B-Rep in association with respective data in the database. The database indexation may be performed by applying the neural network to the B-Reps to output respective single embeddings (e.g., from the output of the neural network encoder or from the output of the pooling module). The database indexation may associate, to each B-Rep the respective single embedding. In other words, the database indexation may store said B-Reps to the database in association with its respective single embeddings. The process may also comprise performing the database indexation. The database indexation may be part of the offline stage. The method of use may comprise obtaining one or more (e.g., a plurality) of B-Reps from a pre-existing database. The method of use may thus create a database (for example, a completely new database if it did not exist before) comprising the one or more B-Reps, each associated with a respective single embedding.

The method of use may for example query the database with the obtained single embedding on the database with the single embeddings. This improves the efficiency of the search compared to the pre-existing database, as the query is based on the low-dimensional representations of the single embeddings.

Examples of the method are now discussed, with reference to FIG.s 2 to 7.

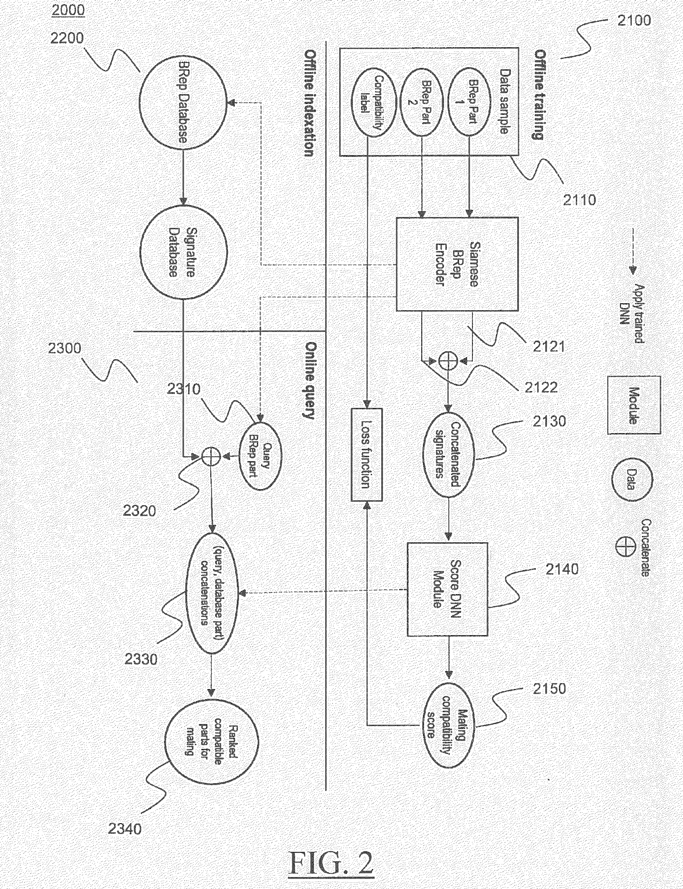

FIG. 2 describes a pipeline 2000 of the method. The method comprises an offline stage that comprises an offline training stage 2100 of the neural network according to the method and an offline database indexation 2200, that is, creating a database of B-Reps, each B-rep being associated to a signature. The pipeline 2000 also comprises an online stage 2300, that is, the method of use.

The offline training stage 2100 is now discussed.

The offline training 2100 aims at providing a database 2110 of pairs of B-Reps having mating compatibility data ("compatibility label"). The offline training simultaneously trains a Siamese B-Rep encoder 2120 that takes as input an pair of B-Rep parts and outputs respective (multi-dimensional) vector embeddings (also called "signatures") 2121 and 2122, and trains a compatibility score module (being a score deep neural network (DNN) module) 2140 that takes as input a concatenation 2130 of the vector embeddings with annotations associated with the input pair of B-Rep parts. The compatibility score module 2140 outputs a compatibility score 2150. The offline training 2100 is end-to-end: a single loss value is computed and backpropagated to adjust the weights of the two modules 2120 and 2140.

As the offline training stage 2100 is a supervised learning, it is now described the annotation of data samples, that is, labeling with mating compatibility data. A data sample is a pair of CAD models in the B-Rep format (such as STEP) that is annotated with a numerical value measuring the compatibility/relevancy of the two parts to be mated together in an assembly.

Data preprocessing. The data samples may be preprocessed so that these can be passed to a DNN architecture.

Design of the architecture. The Siamese B-Rep encoder returns a single fixed-size vector embedding per part. The score module takes as input a concatenation of the two embeddings of the pair outputted by the Siamese B-Rep encoder and outputs a compatibility score.

Training loss. The training loss function measures the distance between the predicted score outputted by the score module and the target mating compatibility data of the pair.

The training 2100 is performed by iterating several times over the annotated dataset.

The offline database indexation 2200 is now discussed. The trained deep learning modules may be used to generalize to unseen data (data samples outside of the training dataset). The trained deep learning modules may be used to create a database that associates B-Reps (e.g. from a pre-existing database) with single embeddings. Thus, the offline indexation 2200 applies the trained deep learning modules and store the outputted vector single embeddings (stemming, for example, from the outputs 2121 and 2122).

The online stage 2300 is now discussed.

Given an input query B-Rep part, the online stage 2300 comprises extracting from the database indexed in 2200 the most compatible parts to be mated with the query.

The online stage 2300 comprises the following sub-tasks:

Obtaining a query vector single embedding/signature. As the query B-Rep may not necessarily exist in the database indexed at 2200 (e.g., it may be a part that a CAD user just designed), the online stage 2300 may apply the trained deep learning modules 2100 to obtain a corresponding single embedding 2310.

Concatenate 2320 all the (query part, indexed part) pairs of single embeddings. Concatenations between the signature of the query part obtained at 2310 and each single embedding signature indexed in the database 2200 may be performed so these are ready to be passed to the trained score module 2140. Thus, if the indexed database contains n parts, the concatenation 2320 obtains with n concatenations.

Applying the trained mating score module 2140 to the concatenation obtained at 2320.

Sorting 2340 the indexed parts by descending order of predicted compatibility score. The method thus returns the top-k of the indexed parts that are suitable to be mated with the query relative to the top-k number of parts.

Data annotation or labeling with mating compatibility data, for supervised learning, is further discussed.

We give here a few examples of pairs annotations of mating compatibility data that would be suitable to perform the desired task. Given a dataset containing CAD assemblies, i.e. CAD parts in the B-Rep format as well as the mating / joint data (defining mates between the parts of an assembly) that assemble them in multi-parts assemblies, the following approaches are possible:

- Approach A: Label positively (set a value of 1) the pairs of parts that have a mating data in the dataset, i.e. the pairs of parts that are mated at least one time together in one of the dataset assemblies. To produce negative samples (set a value of 0), randomly select 2 parts in the entire dataset and make sure they are never mated together in one of the assemblies. Another implementation parameter is the balance of the positive vs. negative samples in the training set.
- Approach B: For each pair of parts being mated together in the dataset, count the number of unique assemblies where this pair is mated, and assign a higher mating compatibility score to the pairs that are represented in several assemblies. That way, pairs that are commonly mated together (e.g. a screw and its nut) will be labeled with a higher value. For a given pair, the mating compatibility data could be:

$$number\_of\_assemblies\_involving\_the\_pair$$

$$10 \times number\_of\_assemblies\_involving\_the\_pair$$

$$2^{number\_of\_assemblies\_involving\_the\_pair}$$

Again, training set may be augmented with negative samples by selecting 2 parts that are never mated together in the entire dataset.

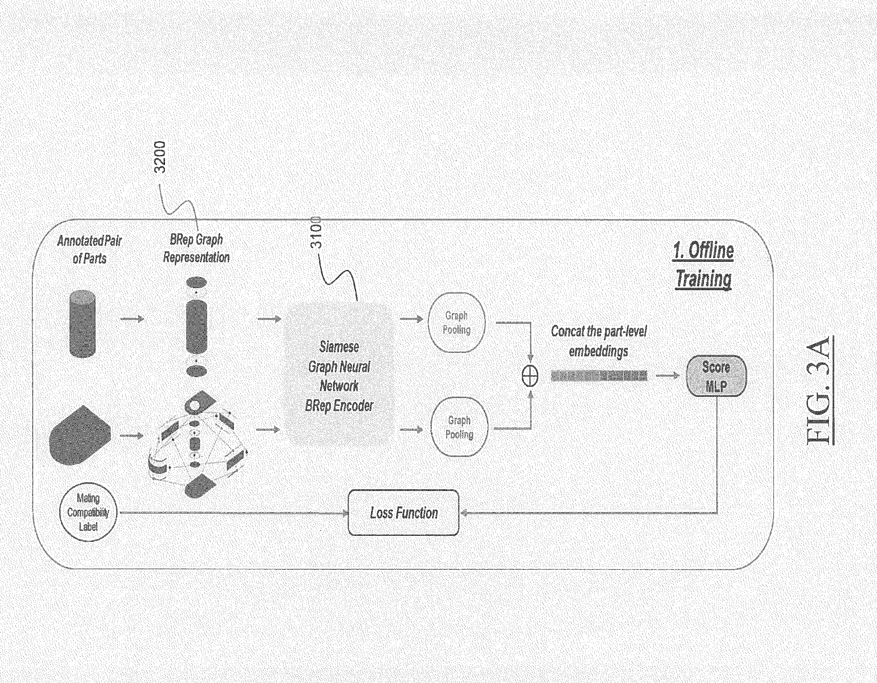

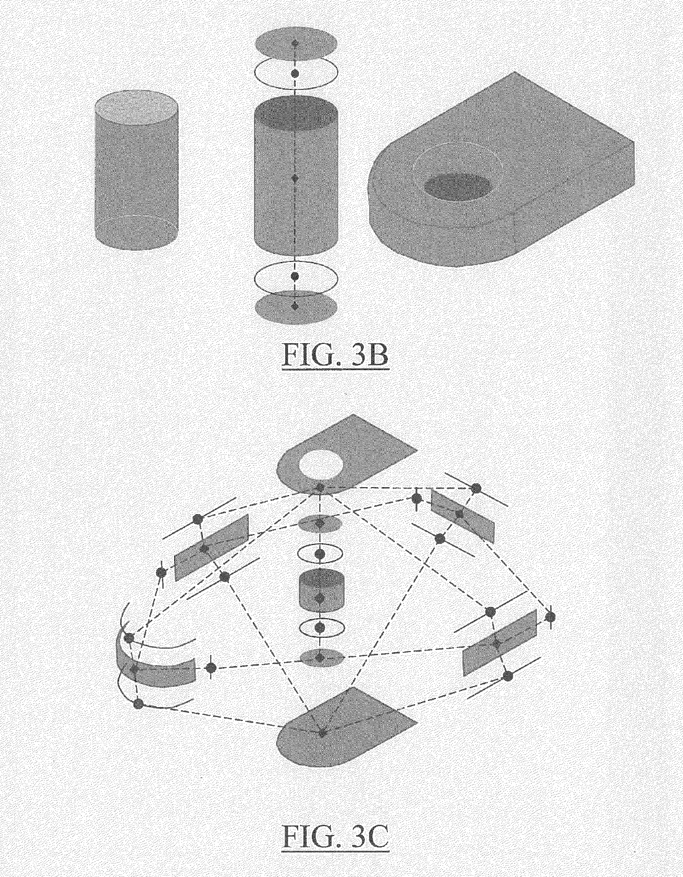

The data preprocessing for the B-Rep parts is further discussed, with reference to FIG.s 3A-3C. FIG. 3A illustrates schematically the data preprocessing, and FIG.s 3B-3C show further views of the exploded parts shown in FIG. 3A.

The data preprocessing to be applied to B-Rep parts may depend on the DNN encoder that will be addressed in the following section. For example, implementations of the neural network may be based on message passing-based encoders such as Siamese Graph Neural Network B-Rep encoder 3100, which take as input a graph B-Rep representation 3200 (B-Rep graph). Such a B-Rep graph can be constructed using a STEP file parser or by loading the parts using a CAD backend and extracting the relevant features. For example, the method may construct a graph where vertices are the solid's edges and faces topological entities and graph edges are defined by adjacency of these topological entities. Vertex features encode the geometrical properties of the corresponding entity (e.g. edge or face type, face area, edge length, etc.). It may also be necessary to pass additional adjacency matrices, indicating the neighboring entities of each type of topological entity.

The design of the neural network is further discussed.

The neural network requires to output only one single embedding $\in \mathbb{R}^d$ per solid from the vector embedding. The method may apply a graph pooling method to the vector embedding, and obtain a single graph-level embedding. Several graph pooling operations can be considered, e.g. Max Pooling or Mean Pooling.

The mating score module has been implemented as a Multi-layer perceptron (MLP), which maps $\mathbb{R}^{2 \times d} \rightarrow \mathbb{R}^1$. It is preferable to keep this module lightweight so it can be applied to an important amount of pairs during the online inference stage.

The training loss is further discussed.

Since the training loss should measure the distance between the predicted score value and the labeled compatibility score, it is linked to the mating compatibility data.

When using binary labels (approach A), the training task becomes a binary classification problem that can be trained using a binary cross entropy loss.

$$BCE = -\frac{1}{N} \sum_{i=0}^{N} y_i \cdot log(\hat{y}_i) + (1 - y_i) \cdot log(1 - \hat{y}_i)$$

For other labeling approaches, such as approach B, a mean squared error loss would be suitable.

$$MSE = \frac{1}{n} \sum_{i=1}^{n} (y_i - \tilde{y}_i)^2$$

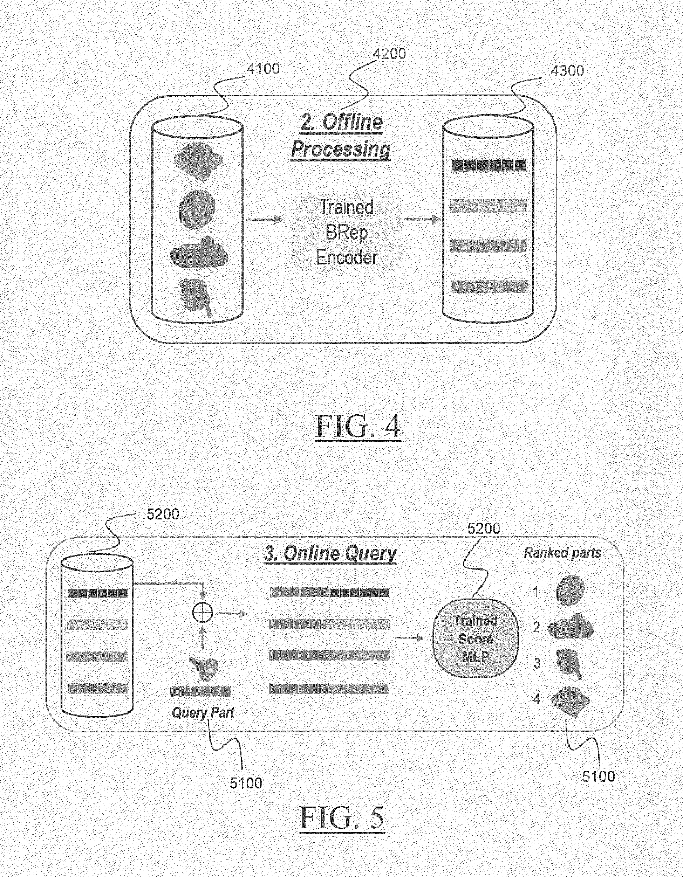

The offline dataset indexation is further discussed, with reference to FIG. 4.

To perform the indexation of a database, the trained encoder 4200 with graph pooling may be applied to B-Reps in a pre-existing database 4100 and store said B-Reps in association with the output single embeddings 4300. Hence, each B-Rep can be mapped to its fixed size vector single embedding. The method may also perform the data preprocessing routine (for obtaining graph B-Reps for each B-Rep), so that the graph neural network can be applied to the samples. When using the trained encoder in experiments, indexing a part database took around 15 seconds for ~3600 parts while running in inference mode on CPU.

The online query / inference stage is further discussed, with reference to FIG. 5

The input query part 5100 is concatenated with a single embedding stored in the database. Said concatenation is then input to the score module 5200. The method may rank the retrieved mate scores 5300.

When running a query, producing the mating score using the mating score module 2140 between the query part and each ~3600 indexed parts took around 0.4 second on CPU. This method can therefore be considered as production-ready. Indeed, this allows online queries in less than a second, it may be integrated into a commercial CAD product and can be seamlessly integrated into a CAD designer workflow.

FIG.s 6 and 7 show the results of the CAD model retrieval. The B-Rep 6100 is the input for the query. The method obtains B-Reps 6200 which are the top four parts which have the best mating score to the B-Rep 6100. The B-Rep 7100 is another input for the query. The method obtains other B-Reps 7200 which are the top four parts which have the best mating score to the other B-Rep 7100.

**Claims**

1. A computer-implemented method of machine-learning for CAD model retrieval based on a mating score, the method comprising:

   - providing a dataset of pairs of Boundary Representations (B-Reps) representing mechanical parts, each pair being labeled with mating compatibility data, the mating compatibility data representing an extent of mating compatibility between the mechanical parts represented by the pair; and
   - training a neural network based on the dataset, the neural network being configured for taking as input a pair of B-reps representing mechanical parts, and outputting a mating score of a pair of single embeddings, each single embedding corresponding to a B-Rep of the pair, the mating score representing a score of mating compatibility between the mechanical parts represented by the pair.

2. The method of claim 1, wherein the neural network comprises:

   - a neural network encoder configured to take as input the pair of B-Reps and output a single embedding for a B-Rep of the pair, and
   - a score neural network configured to take as input a concatenation of the pair of single embeddings and output the mating score.

3. The method of claim 2, wherein the neural network encoder comprises a Siamese graph neural network encoder and/or the score neural network is a multi-layer perceptron neural network.

4. The method of claim 3, wherein the neural network comprises a pooling module applied on the output the Siamese graph neural network encoder and passed as input the multi-layer perceptron neural network.

5. The method of claims 2 to 4, wherein the neural network encoder and the score neural network are trained simultaneously by using a loss, the loss penalizing a disparity between the mating compatibility data and the mating score.

6. A neural network trainable according to the method of any one of claims 1 to 5.

7. A method of use of the neural network according to claim 6, comprising providing a database of B-Reps representing mechanical parts, each B-Rep being associated to a single embedding obtained by applying the neural network to the B-Rep.

8. The method claim 7, comprising:

   - obtaining a single embedding of a B-Rep by applying the neural network to the B-Rep;
   - querying the database with the single embedding, including applying the neural network to pairs each consisting of the single embedding and one of respective single embeddings of one or more B-Reps included in the database;
   - retrieving one or more B-Reps from the database based on the mating score resulting from the application of the neural network.

9. The method of claim 8, further comprises ranking the one or more B-Reps based on the mating scores.

10. The method of any one of claims 1 to 5 or 7 to 9, further comprising performing a database indexation by applying the neural network to the B-Reps to output respective single embeddings, the database indexation associating to each B-Rep a respective single embedding.

11. A database obtainable by the method of claim 10.

12. A computer program comprising instructions which, when executed by a computer system, cause the computer system to perform the method of any one of claims 1 to 5, the method of any one of claims 7 to 9, and/or the method of claim 10.

13. A computer readable storage medium having recorded thereon the program of claim 12, the neural network of claim 6 and/or the database of claim 11.

14. A computer system comprising a processor coupled to a memory, the memory having recorded thereon the program of claim 12, the neural network of claim 6 and/or the database of claim 11.

FIG. 1

FIG. 2

FIG. 3A

FIG. 3B

FIG. 3C

FIG. 4

FIG. 5

6100

6200

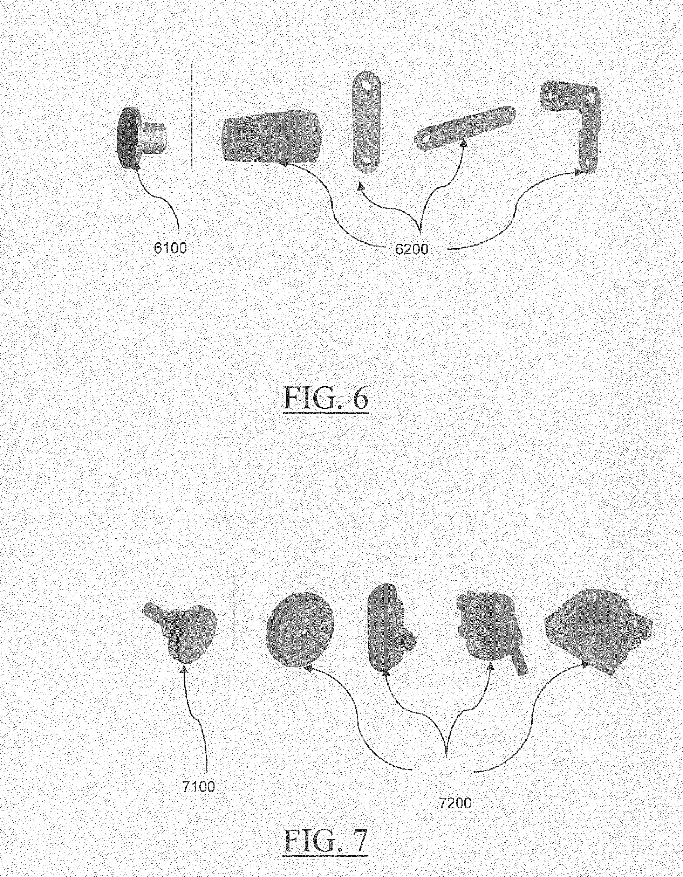

FIG. 6

7100

7200

FIG. 7

Europäisches
Patentamt

European
Patent Office

Office européen
des brevets

**EUROPEAN SEARCH REPORT**

Application Number

EP 23 31 5150

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PRADEEP KUMAR JAYARAMAN ET AL: "UV-Net: Learning from Boundary Representations", ARXIV.ORG, 26 April 2021 (2021-04-26), XP081924003, Retrieved from the Internet: URL:https://arxiv.org/abs/2006.10211v2> * the whole document * * abstract * * section 4 * * section 4.1 * * section 4.2.3 * * figures 4, A.10, A.11 * ----- | 1-14 | INV. G06F30/17 G06N20/00 G06F16/00 G06F30/27 G06N3/045 |
| X | HOU JUNHAO ET AL: "FuS-GCN: Efficient B-rep based graph convolutional networks for 3D-CAD model classification and retrieval", ADVANCED ENGINEERING INFORMATICS, vol. 56, 1 April 2023 (2023-04-01), XP087328795, DOI: 10.1016/J.AEI.2023.102008 * the whole document * * abstract * * figure 1 * * section 8 * * section 8.4 * * figures 6,7 * ----- | 1-14 | |
| X | US 2023/111048 A1 (PLANCHE BENJAMIN [US] ET AL) 13 April 2023 (2023-04-13) * the whole document * * paragraph [0006] * * paragraph [0036] * ----- -/-- | 1-14 | TECHNICAL FIELDS SEARCHED (IPC) G06F G06N |

The present search report has been drawn up for all claims

| Place of search | Date of completion of the search | Examiner |
|---|---|---|
| Munich | 27 September 2023 | Rungger, Matthias |

Europäisches
Patentamt

European
Patent Office

Office européen
des brevets

**EUROPEAN SEARCH REPORT**

Application Number

EP 23 31 5150

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BENJAMIN JONES ET AL: "AutoMate: A Dataset and Learning Approach for Automatic Mating of CAD Assemblies", ARXIV.ORG, 4 October 2021 (2021-10-04), XP091067828, Retrieved from the Internet: URL:https://arxiv.org/abs/2105.12238v2> * the whole document * * abstract * * figures 1-3 * * section 6 * ----- | 1-14 | |

TECHNICAL FIELDS
SEARCHED      (IPC)

The present search report has been drawn up for all claims

| Place of search | Date of completion of the search | Examiner |
|---|---|---|
| Munich | 27 September 2023 | Rungger, Matthias |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.........................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 23 31 5150

This annex lists the patent family members relating to the patent documents cited in the above-mentioned European search report.
The members are as contained in the European Patent Office EDP file on
The European Patent Office is in no way liable for these particulars which are merely given for the purpose of information.

27-09-2023

| Patent document cited in search report | | Publication date | Patent family member(s) | | Publication date |
|---|---|---|---|---|---|
| US 2023111048 | A1 | 13-04-2023 | CN 115605862 | A | 13-01-2023 |
| | | | EP 4097604 | A1 | 07-12-2022 |
| | | | US 2023111048 | A1 | 13-04-2023 |
| | | | WO 2021178000 | A1 | 10-09-2021 |

For more details about this annex : see Official Journal of the European Patent Office, No. 12/82

EPO FORM P0459